# EUROPÄISCHE PATENTSCHRIFT

(11) **EP 0 599 121 B1**
(45) Veröffentlichungstag und Bekanntmachung des Hinweises auf die Patenterteilung: **27.09.1995**
(21) Anmeldenummer: 93118076.4
(22) Anmeldetag: 08.11.1993
(51) Int. Cl.: H05K 3/42

(54) **Verfahren zum Herstellen von durchkontaktierten Leiterplatten mit sehr kleinen oder keinen Lötaugen**
Process for producing plated through-hole printed circuit boards having very small solder lands or no solder lands
Procédé de fabrication de plaques de circuit imprimé à trous traversant comportant de très petits oeillets de soudage ou n'en comportant pas

(30) Priorität: 23.11.1992 DE 4239327
(43) Veröffentlichungstag der Anmeldung: 01.06.1994
(73) Patentinhaber: Siemens Nixdorf Informationssysteme Aktiengesellschaft, 33102 Paderborn (DE)
(72) Erfinder: Merkenschlager, Hans-Hermann, Dipl.-Ing., D-86179 Augsburg (DE); Zeidler, Wolfgang, D-86179 Augsburg (DE)
(74) Vertreter: Fuchs, Franz-Josef, Dr.-Ing.

(56) Entgegenhaltungen:
- EP-A- 0 178 864
- DE-A- 3 917 923
- PATENT ABSTRACTS OF JAPAN vol. 013, no. 301 (E-785)11. Juli 1989 & JP-A-01 080 097 (MITSUBISHI ELECTRIC CORP) 24. März 1989
- PATENT ABSTRACTS OF JAPAN vol. 013, no. 558 (E-858)12. Dezember 1989 & JP-A-01 231 397 (NEC CORP) 14. September 1989

## Beschreibung

Die Erfindung betrifft ein Verfahren zum Herstellen von durchkontaktierten Leiterplatten mit sehr kleinen oder keinen Lötaugen um die Durchkontaktierungslöcher.

Bei der Herstellung von Leiterplatten mit sehr kleinen Lötaugen um die durchkontaktierten Bohrungen besteht z.B. beim Fotofoliententing-Verfahren die Gefahr, daß die Kupferschicht aus den Bohrungen herausgeätzt wird und damit die Funktion der Platte gefährdet ist. Zur Vermeidung dieses Nachteils sind bereits unterschiedliche technische Verfahrensweisen bekannt, wie z.B. das Metallresist-Verfahren. Durchkontaktierte Leiterplatten werden bisher überwiegend in sogenannter Metallresist-Technik, nicht aber im Tenting-Verfahren hergestellt. Gegenüber dem Tenting-Verfahren, bei dem, wie aus DE-A-31 08 080 bekannt, vor dem Ätzschritt das Leiterbild, die Lötaugen und die Durchkontaktierungslöcher der Leiterplatte mit Fotofolie abgedeckt werden, sind bei Anwendung der Metallresist-Technik mehr Galvanikschritte erforderlich. Beim Tenting-Verfahren besteht die Gefahr, vor allem bei kleinen Lötaugen oder gar keinen Lötaugen, das die die Bohrungen abdeckende Fotofolie aufreißt, dadurch Ätze in die Durchkontaktierungsbohrungen eindringt, die die Kupfermetallisierung in den Durchkontaktierungsbohrungen abträgt und damit die Durchkontaktierung selbst zerstört. Um dies zu vermeiden, ist z.B. ebenfalls aus der DE-A-31 08 080 bekannt, vor dem Aufbringen der Fotofolie und vor dem Ätzprozeß die Durchkontaktierungsbohrungen mit Siebdruckpaste zu füllen und damit gegen das Eindringen von Ätze zu schützen.

Diese Methode ist aber relativ umständlich und aufwendig. Aus der DE-A-39 17 923 ist es außerdem bekannt, die Leiterplatte vor dem Beschichten mit Fotofolie in eine Lösung einzutauchen, die auf allen Kupferflächen eine ätzfeste Schutzschicht erzeugt. Diese Schutzschicht wird anschließend von der Oberfläche der Leiterplatte mit Ausnahme in den Durchkontaktierungsbohrungen wieder entfernt. Danach werden die Leiterbahnen und die Durchkontaktierungsbohrungen der Leiterplatte mit einer Fotofolie abgedeckt. Die Leiterplatte wird dann geätzt und nach dem Ätzen und dem Entschichten der Fotofolie wird die ätzfest Schutzschicht in den Durchkontaktierungslöchern wieder entfernt.

Der vorliegenden Erfindung liegt die Aufgabe zugrunde, ein weiteres Verfahren zum Herstellen von durchkontaktierten Leiterplatten mit sehr kleinen oder keinen Lötaugen anzugeben, bei dem die mit dem Aufbringen einer Fotofolie verbundenen Nachteile vermieden werden.

Zur Lösung dieser Aufgabe wird gemäß der Erfindung dabei so verfahren, daß die Leiterplatte und die metallisierten Bohrungen mit einem gegen alkalische Ätze beständigen, jedoch in Säure löslichen SChutzfilm versehen werden, daß der Schutzfilm von der Leiterplattenoberfläche mechanisch entfernt wird, daß nach dem Beschichten und Entwickeln des Fotolacks das Ätzen mit alkalischer Ätze erfolgt und danach die Fotolackschicht und der Schutzfilm in den Bohrungen mittels Säure entfernt werden.

Anstelle von Säure kann auch jedes weitere geeignete Lösungsmittel verwendet werden.

Der Vorteil des Einsatzes von Fotolack gegenüber Fotofolie liegt in geringeren Fertigungskosten bzw. in der Ausbeuteerhöhung bei der Herstellung feiner Leiterbildstrukturen.

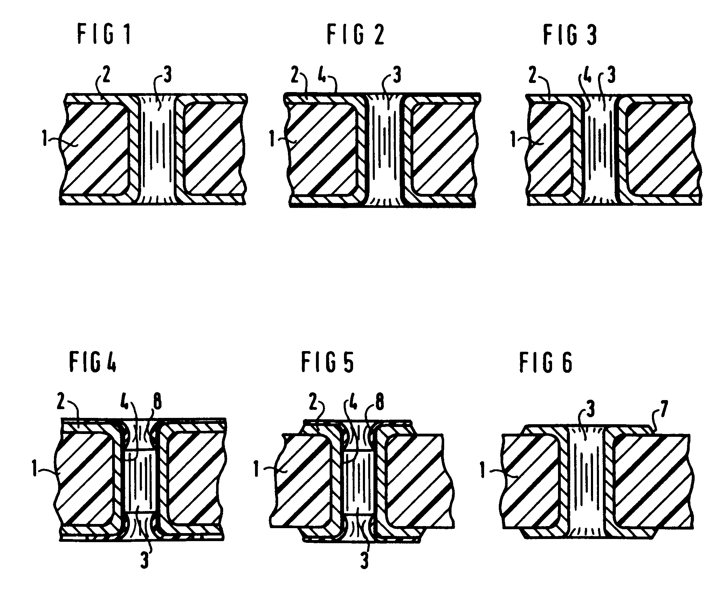

Anhand der Ausführungsbeispiele nach den Figuren 1 bis 6 wird die Erfindung näher erläutert.

Figur 1 zeigt als Schnittdarstellung einen Teil einer Leiterplatte 1 mit einer Kupferbeschichtung 2, die sich auch im Innern der Bohrungen 3 fortsetzt. Durch Eintauchen einer solchen Leiterplatte z.B. in eine Imitatssollösung bildet sich auf allen Kupferflächen 2 der Leiterplatte 1 ein ätzfester, jedoch in Säure löslicher Schutzfilm 4, wie in Figur 2 angedeutet ist. Anschließend wird dieser ätzfeste Schutzfilm 4 von der Oberfläche der Leiterplatte 1 z.B. durch Bürsten wieder entfernt, bleibt aber in den Bohrungen 3 erhalten, wie Figur 3 zeigt. Danach wird die Leiterplattenoberfläche mit einer Fotolackschicht 8 beschichtet (Figur 4) und nach dem Entwickeln des Fotolacks das Ätzen mit alkalischer Ätze vorgenommen (Figur 5). Danach wird die teilweise in die Bohrungen an den Rändern eingedrungene Fotolackschicht 8 und der Schutzfilm 4 in den Bohrungen 3 mittels Säure entfernt. Figur 6 zeigt schließlich das Ergebnis des Verfahrens nach der Erfindung, d.h. die außerhalb der Bohrung 3 und seiner Lötränder weggeätzte Kupferschicht 7 und die unversehrte durchkontaktierte Bohrung 3.

## Patentansprüche

1. Verfahren zum Herstellen von durchkontaktierten Leiterplatten mit sehr kleinen oder keinen Lötaugen um die Durchkontaktierungsbohrungen,
**dadurch gekennzeichnet,**
daß die Leiterplatte (1) und die metallisierten Bohrungen (3) mit einem gegen alkalische Ätze beständigen, jedoch in Säure löslichen Schutzfilm (4) versehen werden, daß der Schutzfilm (4) von der Leiterplattenoberfläche mechanisch entfernt wird und diese mit Fotolack beschichtet wird, daß nach dem Entwickeln des Fotolacks das Ätzen mit alkalischer Ätze erfolgt und danach die Fotolackschicht (8) und der Schutzfilm (4) in den Bohrungen mittels Säure entfernt werden.

## Claims

1. Process for producing plated-through printed circuit boards having very small solder lands or no solder lands around the plated-through holes, characterized in that the printed circuit board (1) and the metallized holes (3) are provided with a protective film (4) which is resistant to alkaline etchant but is soluble in acid, in that the protective film (4) is mechanically removed from the surface of the printed circuit board and the said surface is coated with photoresist, in that etching with alkaline etchant takes place after developing the photoresist and afterwards the photoresist layer (8) and the protective film (4) in the holes are removed by means of acid.

## Revendications

1. Procédé de fabrication de plaques de circuit imprimé à trous traversants, comportant de très petits oeillets de soudage ou pas d'oeillets de soudage autour des trous traversants,
caractérisé en ce qu'il consiste
à munir la plaque de circuit imprimé (1) et les trous (3) métallisés d'une pellicule de protection (4) résistante à l'attaque alcaline mais soluble dans un acide, à éliminer mécaniquement la pellicule de protection (4) de la surface de la plaque de circuit imprimé et à revêtir cette surface d'un vernis photosensible, à effectuer après le développement du vernis photosensible l'attaque chimique par un agent d'attaque alcalin et à éliminer ensuite la couche (8) de vernis photosensible et la pellicule de protection (4) dans les trous au moyen d'acide.
